# EUROPÄISCHE PATENTSCHRIFT

(11) **EP 3 836 767 B1**
(45) Veröffentlichungstag und Bekanntmachung des Hinweises auf die Patenterteilung: **07.06.2023**
(21) Anmeldenummer: 20201258.9
(22) Anmeldetag: 12.10.2020
(51) Int. Cl.: H05K 7/20, H05K 7/14, B25F 5/00

(54) **ELEKTRONIKMODUL FÜR EIN ELEKTROWERKZEUG**
ELECTRONICS MODULE FOR AN ELECTRIC TOOL
MODULE ÉLECTRONIQUE POUR UN OUTIL ÉLECTRIQUE

(30) Priorität: 12.12.2019 DE 102019134161
(43) Veröffentlichungstag der Anmeldung: 16.06.2021
(73) Patentinhaber: Metabowerke GmbH, 72622 Nürtingen (DE)
(72) Erfinder: Hiller, Matthias, 72657 Altenriet (DE)
(74) Vertreter: Schmid, Wolfgang

(56) Entgegenhaltungen:
- DE-A1-102007 063 310
- US-A1- 2007 247 817

## Beschreibung

Die Erfindung betrifft ein Elektronikmodul für ein Elektrowerkzeug, mit einer Platine, auf der mehrere elektronische Bauelemente angebracht sind, nach der im Oberbegriff von Anspruch 1 näher definierten Art. Des Weiteren betrifft die Erfindung ein Elektrowerkzeug.

Ein gattungsgemäßes Elektronikmodul ist aus der WO 2010/020459 A1 bekannt.

Die DE 40 38 788 A1 beschreibt ein Gehäuse zur Aufnahme elektrischer Schaltungen und zur Abfuhr von überschüssiger Wärme, die von den elektrischen Schaltungen erzeugt wird. Das Gehäuse ist von mehreren Seiten umschlossen und dient gleichzeitig als Vergussrahmen für die Schaltung, wobei ein Gehäusewandbereich gleichzeitig ein Kühlkörper ist. Einen ähnlichen Stand der Technik zeigt auch die EP 1 783 882 A2.

In der EP 2 873 494 A2 ist ein Winkelschleifer beschrieben, dessen Leiterplatte einen Kühlkörper beinhaltet, der auf einem integrierten Leistungsmodul angeordnet ist.

Die DE 10 2007 063 310 A1 beschreibt eine Elektronikeinheit zum Einsatz in einem Elektrowerkzeug mit einem Becherelement mit einem Bodenteil und Seitenteilen, einem u-förmigen Kühlelement mit einem Deckelteil und Schenkelteilen und einer Leiterplatte, die in dem Becherelement angeordnet ist und über ein Befestigungselement an dem Kühlelement fixiert ist. Das u-förmige Kühlelement ist so auf das Becherelement aufgesetzt, dass eine dem Bodenteil gegenüberliegende Öffnung des Becherelementes von dem Deckelteil des Kühlelements abgedeckt wird, so dass ein Abschnitt der Öffnung des Becherelements unbedeckt verbleibt.

Aus der US 2007/247817 A1 ist ein Leistungsadapter mit einem Gehäuse bekannt, das aus einer unteren Abdeckschale und einer oberen Abdeckschale gebildet ist und einen sich über die untere Abdeckschale erstreckenden Luftdurchlass und eine Auslassöffnung in der oberen Abdeckschale aufweist.

Ein grundsätzliches Problem bei solchen Elektronikmodulen besteht in der Abführung der Wärme, welche von den elektronischen Bauelementen erzeugt wird. Die oben beschriebenen Lösungen sind teilweise in der Lage, eine bestimmte Wärmemenge abzuführen, häufig jedoch nicht in einem ausreichenden Umfang. Ein weiteres Problem, das die bekannten Konstruktionen nicht zufriedenstellend lösen, besteht in dem vergleichsweise großen Platzbedarf der Kühlelemente sowie der Verschmutzungsanfälligkeit der elektronischen Bauelemente.

Es ist daher Aufgabe der vorliegenden Erfindung, ein Elektronikmodul für ein Elektrowerkzeug zu schaffen, das eine zuverlässige Wärmeabfuhr für die elektronischen Bauelemente und einen Schutz derselben vor Verschmutzung bietet.

Erfindungsgemäß wird diese Aufgabe durch die in Anspruch 1 genannten Merkmale gelöst.

Durch die Anordnung der Platine innerhalb des wannenartigen Aufnahmeelements ist es möglich, die Platine vollständig mit einer Vergussmasse zu vergießen bzw. in die Vergussmasse einzugießen, die sich ebenfalls innerhalb des wannenartigen Aufnahmeelements befindet. Auf diese Weise ergibt sich ein sehr guter Schutz der Platine vor Verschmutzungen und ähnlichen äußeren Einflüssen.

Dabei ist erfindungsgemäß nicht nur die Platine, sondern auch das Kühlelement mit der Vergussmasse vergossen, sodass auch die innerhalb des Kühlelements angeordneten elektronischen Bauelemente vollständig geschützt sind. Im Gegensatz zu der Platine ist das Kühlelement allerdings nicht vollständig eingegossen.

Durch die Ausführung des Kühlelements aus zwei Halbschalen ist es auf sehr einfache Weise möglich, die elektronischen Bauelemente mit dem Kühlelement zu verbinden und anschließend auf der Platine zu montieren.

Eine besonders praxisrelevante Ausführungsform der Erfindung kann darin bestehen, dass die mit wenigstens einer der Halbschalen verbundenen elektronischen Bauelemente elektronische Schaltelemente und/oder Gleichrichter sind.

Obwohl Kondensatoren an sich nicht mittels eines zusätzlichen Kühlelements gekühlt werden müssen, kann eine weitere Ausgestaltung der Erfindung darin bestehen, dass mit beiden Halbschalen jeweils wenigstens ein elektronisches Bauelement verbunden ist, und dass zwischen den mit den Halbschalen verbundenen elektronischen Bauelementen wenigstens ein Kondensator angeordnet ist. Auf diese Weise ist der wenigstens ein Kondensator ebenfalls vor äußeren Einflüssen geschützt.

Der Schutz der innerhalb der beiden die Umhüllung bildenden Halbschalen angeordneten elektronischen Bauelemente kann noch weiter verbessert werden, wenn der Bereich, in dem die Halbschalen aneinander anliegen, mit der Vergussmasse vergossen sind.

Dabei ergibt sich eine besonders gute Abdichtung des Bereichs, an dem die Halbschalen aneinander anliegen, wenn die Halbschalen in dem Bereich, in dem sie aneinander anliegen, jeweils mit Fasen versehen sind, wobei die Fasen zweier Halbschalen eine Vertiefung zum Aufnehmen der Vergussmasse bilden.

In einer weiteren sehr vorteilhaften Ausführungsform der Erfindung kann vorgesehen sein, dass die elektronischen Bauelemente mit den Halbschalen verschraubt sind. Dies ermöglicht eine gleichermaßen einfache wie sichere Verbindung der elektronischen Bauelemente mit den das Kühlelement bildenden Halbschalen.

Diese Verbindung kann besonders einfach in die Praxis umgesetzt werden, wenn die Halbschalen jeweilige Gewindebohrungen aufweisen, in welche durch Durchgangsbohrungen in den elektronischen Bauelementen verlaufende Schrauben eingreifen.

Des Weiteren kann vorgesehen sein, dass die Halbschalen als Zinkdruckgussbauteile ausgebildet sind. Auf diese Weise wird eine besonders gute Wärmeabfuhr erreicht.

Alternativ ist es zum Erreichen einer guten Wärmeabfuhr auch möglich, dass die Halbschalen als Aluminiumdruckgussbauteile ausgebildet sind.

Ein Elektrowerkzeug mit einem erfindungsgemäßen Elektronikmodul ist in Anspruch 10 angegeben.

Ergänzend sei darauf hingewiesen, dass Begriffe, wie "umfassend" "aufweisen" oder "mit" keine anderen Merkmale oder Schritte ausschließen. Ferner schließen Begriffe "ein" oder "das", die auf einer Einzahl von Schritten oder Merkmalen hinweisen, keine Mehrzahl von Merkmalen oder Schritten aus und umgekehrt.

Weitere Merkmale und Vorteile der Erfindung ergeben sich aus der nachfolgenden Beschreibung eines Ausführungsbeispiels der Erfindung. Die Figuren zeigen mehrere Merkmale der Erfindung in Kombination miteinander. Selbstverständlich vermag der Fachmann diese jedoch auch losgelöst voneinander zu betrachten und gegebenenfalls zu weiteren sinnvollen Unterkombinationen zu kombinieren, ohne hierfür erfinderisch tätig werden zu müssen.

Es zeigen schematisch:
- Figur 1: eine perspektivische Ansicht eines erfindungsgemäßen Elektronikmoduls mit einem vollständig geschlossenen Kühlelement;
- Figur 2: das Elektronikmodul aus Figur 1, bei dem eine der Halbschalen entfernt wurde; und
- Figur 3: das Elektronikmodul aus Figur 1, bei dem die andere Halbschale entfernt wurde.

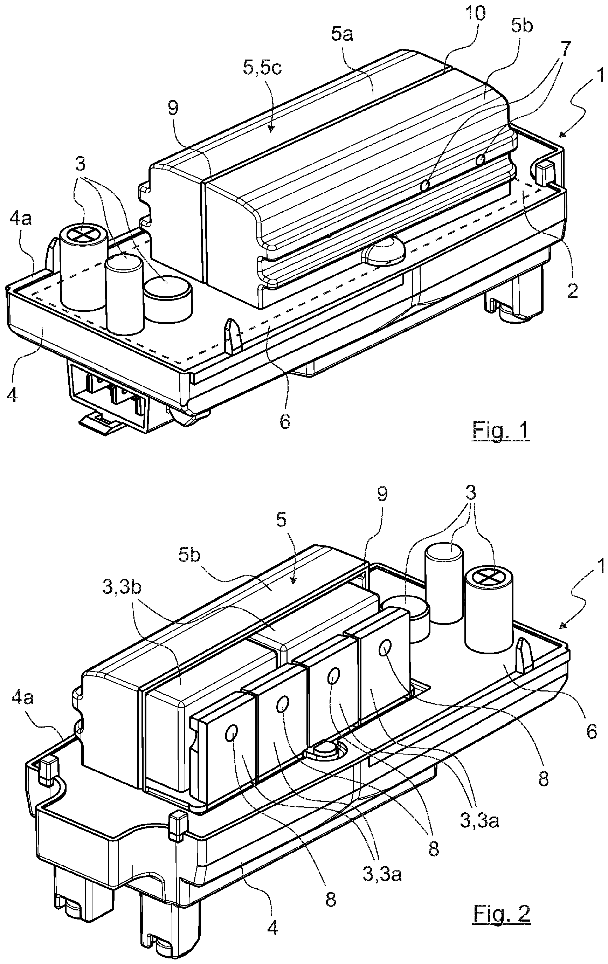

Figur 1 zeigt ein Elektronikmodul 1 für ein in seiner Gesamtheit nicht dargestelltes Elektrowerkzeug, beispielsweise einen Winkelschleifer. Das nachfolgend beschriebene Elektronikmodul 1 ist jedoch auch für andere Elektrowerkzeuge geeignet.

Das Elektronikmodul 1 weist eine in Figur 1 lediglich mit einer gestrichelten Linie angedeutete Platine 2 auf, auf der mehrere elektronische Bauelemente 3 angebracht sind. Des Weiteren weist das Elektronikmodul 1 ein wannenartiges Aufnahmeelement 4 zur Aufnahme der Platine 2 und ein Kühlelement 5 zum Kühlen der elektronischen Bauelemente 3 auf. Das Kühlelement 5 ist dafür vorgesehen, die von den elektronischen Bauelementen 3 erzeugte Abwärme aufzunehmen und an die Umgebung abzugeben. Da das Kühlelement 5 eine erheblich größere Oberfläche als die elektronischen Bauelemente 3 aufweist, kann auf diese Weise eine deutlich höhere Wärmemenge abgeführt werden.

Die Platine ist derart innerhalb des wannenartigen Aufnahmeelements 4 angeordnet, dass ein oberer Rand 4a des wannenartigen Aufnahmeelements 4 die Platine 2 überragt. Mit anderen Worten, die Platine 2 ist vertieft in dem wannenartigen Aufnahmeelement 4 angeordnet. Des Weiteren ist die Platine 2 mit einer Vergussmasse 6 in dem wannenartigen Aufnahmeelement 4 eingegossen. Im vorliegenden Fall ist die Vergussmasse 6 bis zu einer solchen Höhe in dem wannenartigen Aufnahmeelement 4 enthalten, dass auch das Kühlelement 5 in die Vergussmasse 6 eingebettet ist. Dadurch ergibt sich eine vollkommene Abdichtung der Platine 2, so dass keinerlei Verschmutzung mehr in den Bereich der Platine 2 gelangen kann. Für die Vergussmasse 6 können an sich bekannte Materialien verwendet werden.

Das Kühlelement 5 ist im vorliegenden Fall aus zwei aneinander anliegenden Halbschalen 5a und 5b gebildet, die gemeinsam eine Umhüllung 5c bilden, innerhalb welcher die elektronischen Bauelemente 3 angeordnet sind. Die beiden Halbschalen 5a und 5b, die gemeinsam die Umhüllung 5c bilden, erzeugen zusammen mit der Vergussmasse 6 also einen komplett abgeschlossenen Raum. Durch die Ausführungsform des Kühlelements 5 mit den beiden Halbschalen 5a und 5b können die elektronischen Bauelemente 3 sehr einfach mit denselben verbunden werden. Statt der zweiteiligen Ausführung mit den beiden Halbschalen 5a und 5b könnte das Kühlelement 5 grundsätzlich auch einteilig ausgebildet sein.

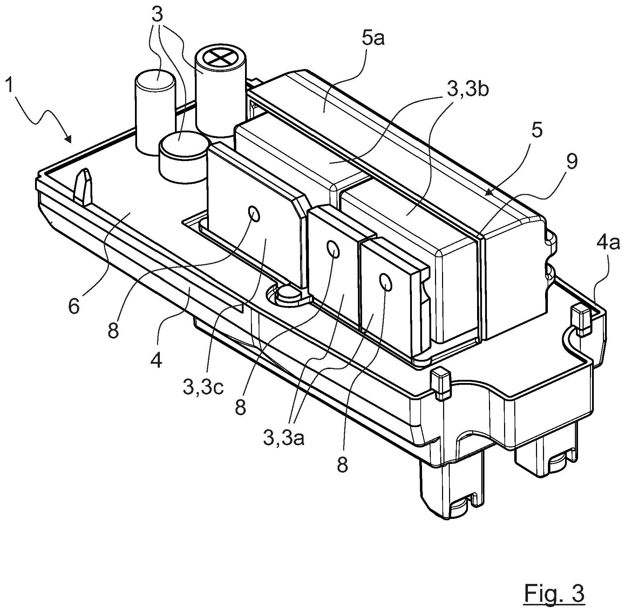

In den Figuren 2 und 3, in denen jeweils eine der Halbschalen 5a bzw. 5b weggelassen wurde, sind die elektronischen Bauelemente 3 näher zu erkennen. In der Darstellung von Figur 2 sind insgesamt vier als elektronische Schaltelemente 3a ausgebildete elektronische Bauelemente 3 sowie zwei als Kondensatoren 3b ausgebildete elektronische Bauelemente 3b zu erkennen. Figur 3 zeigt zwei weitere als elektronische Schaltelemente 3a ausgebildete elektronische Bauelemente 3 sowie ein als Gleichrichter 3c ausgebildetes elektronisches Bauelement 3. Vorzugsweise weist das Elektrowerkzeug einen bürstenlosen Elektromotor auf, für den die genannten elektronischen Bauelemente 3 benötigt werden.

Durch die Anordnung der Kondensatoren 3b innerhalb des Kühlelements 5 sind diese zusätzlich gegen äußere Einflüsse geschützt, auch wenn sie keine übermäßige Wärmeentwicklung aufweisen. Selbstverständlich sind auch andere Ausführungsformen, Anordnungen und Anzahlen der elektronischen Bauelemente 3 denkbar.

Im vorliegenden Fall sind die elektronischen Schaltelemente 3a und der Gleichrichter 3c mit den Halbschalen 5a und 5b verschraubt. Hierzu weisen die Halbschalen 5a und 5b jeweilige nur in Figur 1 und dort auch nur teilweise erkennbare Gewindebohrungen 7 auf, in welche durch Durchgangsbohrungen 8 in den elektronischen Bauelementen 3 verlaufende, nicht dargestellte Schrauben eingreifen. Zwischen den mit den Halbschalen 5a und 5b verschraubten elektronischen Schaltelemente 3a und dem Gleichrichter 3c sind im vorliegenden Fall die beiden Kondensatoren 3b angeordnet.

Durch dieses Verschrauben liegen die elektronischen Bauelemente 3 unmittelbar an den Halbschalen 5a und 5b des Kühlelements 5 an und haben einen engen Kontakt zu denselben, so dass die im Betrieb von den elektronischen Bauelementen 3 erzeugte Wärme unmittelbar an das Kühlelement 5 abgegeben wird. Alternativ zu dem Verschrauben der elektronischen Bauelemente 3 mit dem Kühlelement 5 wäre es auch möglich, diese Bauteile mittels Klammern oder ähnlichem miteinander zu verbinden. Allerdings stellt das Verschrauben der elektronischen Bauelemente 3 mit den Halbschalen 5a und 5b eine sehr einfache und zuverlässige Vorgehensweise dar.

Um die Wärme aufnehmen und an die Umgebung abgeben zu können, sind die Halbschalen 5a und 5b des Kühlelements 5 vorzugsweise als Zinkdruckgussbauteile oder als Aluminiumdruckgussbauteile ausgebildet.

Die elektronischen Bauelemente 3, im vorliegenden Fall die elektronischen Schaltelemente 3a und der Gleichrichter 3c, werden vor der Montage der beiden Halbschalen 5a und 5b mit den Halbschalen 5a und 5b verschraubt und anschließend auf der Platine 2 montiert. Dadurch ergibt sich eine Verbindung der Halbschalen 5a und 5b mit der Platine 2 über die elektronischen Bauelemente 3, die mit der Platine 2 verlötet oder auf andere Art und Weise verbunden werden können. Im vorliegenden Fall berührt das Kühlelement 5 die Platine 2 somit nicht direkt. Eine solche Ausführungsform, bei der das Kühlelement 5 an der Platine 2 anliegt, wäre jedoch grundsätzlich denkbar.

Zusätzlich zu dem oben beschriebenen Vergießen der Halbschalen 5a und 5b wird auch der Bereich, in dem die Halbschalen 5a und 5b aneinander anstoßen, mit der Vergussmasse 6 vergossen. Dies ist in den Figuren jedoch nicht dargestellt. Hierzu weisen die Halbschalen 5a und 5b in dem Bereich, in dem sie aneinander anliegen, jeweilige Fasen 9 auf, wobei die Fasen 9 so gestaltet sind, dass sie beim aneinander Anliegen der beiden Halbschalen 5a und 5b eine Vertiefung 10 zum Aufnehmen der Vergussmasse 6 bilden.

## Patentansprüche

1. Elektronikmodul (1) für ein Elektrowerkzeug, mit einer Platine (2), auf der mehrere elektronische Bauelemente (3) angebracht sind, mit einem wannenartigen Aufnahmeelement (4) zur Aufnahme der Platine (2) und mit einem Kühlelement (5) zum Kühlen der elektronischen Bauelemente (3),
wobei die Platine (2) derart innerhalb des wannenartigen Aufnahmeelements (4) angeordnet ist, dass ein oberer Rand (4a) des wannenartigen Aufnahmeelements (4) die Platine (2) überragt, wobei die Platine (2) mit einer Vergussmasse (6) in dem wannenartigen Aufnahmeelement (4) vergossen ist, **dadurch gekennzeichnet, dass** das Kühlelement (5) in die Vergussmasse (6) eingebettet ist, und dass das Kühlelement (5) aus zwei aneinander anliegenden Halbschalen (5a,5b) gebildet ist, wobei die elektronischen Bauelemente (3) mit wenigstens einer der Halbschalen (5a,5b) verbunden und innerhalb einer durch die Halbschalen (5a,5b) gebildeten Umhüllung (5c) angeordnet sind.

2. Elektronikmodul nach Anspruch 1,
**dadurch gekennzeichnet, dass** die mit wenigstens einer der Halbschalen (5a,5b) verbundenen elektronischen Bauelemente (3) elektronische Schaltelemente (3a) und/oder Gleichrichter (3c) sind.

3. Elektronikmodul nach Anspruch 2,
**dadurch gekennzeichnet, dass** mit beiden Halbschalen (5a,5b) jeweils wenigstens ein elektronisches Bauelement (3) verbunden ist, und dass zwischen den mit den Halbschalen (5a,5b) verbundenen elektronischen Bauelementen (3) wenigstens ein Kondensator (3b) angeordnet ist.

4. Elektronikmodul nach Anspruch 1, 2 oder 3,
**dadurch gekennzeichnet, dass** der Bereich, in dem die Halbschalen (5a,5b) aneinander anliegen, mit der Vergussmasse (6) vergossen sind.

5. Elektronikmodul nach Anspruch 4,
**dadurch gekennzeichnet, dass** die Halbschalen (5a,5b) in dem Bereich, in dem sie aneinander anliegen, jeweils mit Fasen (9) versehen sind, wobei die Fasen (9) zweier Halbschalen (5a,5b) eine Vertiefung (10) zum Aufnehmen der Vergussmasse (6) bilden.

6. Elektronikmodul nach einem der Ansprüche 1 bis 5,
**dadurch gekennzeichnet, dass** die elektronischen Bauelemente (3) mit den Halbschalen (5a,5b) verschraubt sind.

7. Elektronikmodul nach Anspruch 6,
**dadurch gekennzeichnet, dass** die Halbschalen (5a,5b) jeweilige Gewindebohrungen (7) aufweisen, in welche durch Durchgangsbohrungen (8) in den elektronischen Bauelementen (3) verlaufende Schrauben eingreifen.

8. Elektronikmodul nach einem der Ansprüche 1 bis 7,
**dadurch gekennzeichnet, dass** die Halbschalen (5a,5b) als Zinkdruckgussbauteile ausgebildet sind.

9. Elektronikmodul nach einem der Ansprüche 1 bis 7,
**dadurch gekennzeichnet, dass** die Halbschalen (5a,5b) als Aluminiumdruckgussbauteile ausgebildet sind.

10. Elektrowerkzeug mit einem Elektronikmodul (1) nach einem der Ansprüche 1 bis 9.

## Claims

1. Electronic module (1) for a power tool, having a printed circuit board (2) on which a plurality of electronic components (3) are mounted, having a trough-like receiving element (4) for receiving the printed circuit board (2) and having a cooling element (5) for cooling the electronic components (3), the circuit board (2) being arranged within the trough-like receiving element (4) in such a way that an upper edge (4a) of the trough-like receiving element (4) projects beyond the circuit board (2), the circuit board (2) being cast with a casting compound (6) in the trough-like receiving element (4),
**characterized in that** the cooling element (5) is embedded in the casting compound (6), and **in that** the cooling element (5) is formed from two half-shells (5a, 5b) which bear against one another, the electronic components (3) being connected to at least one of the half-shells (5a, 5b) and being arranged within an enclosure (5c) formed by the half-shells (5a, 5b).

2. Electronic module according to claim 1,
**characterized in that** the electronic components (3) connected to at least one of the half-shells (5a, 5b) are electronic switching elements (3a) and/or rectifiers (3c).

3. Electronic module according to claim 2,
**characterized in that** at least one electronic component (3) is connected to each of the two half-shells (5a, 5b), and **in that** at least one capacitor (3b) is arranged between the electronic components (3) connected to the half-shells (5a, 5b).

4. Electronic module according to claim 1, 2 or 3,
**characterized in that** the region in which the half-shells (5a, 5b) bear against one another is cast with the casting compound (6).

5. Electronic module according to claim 4,
**characterized in that** the half-shells (5a, 5b) are each provided with chamfers (9) in the region in which they bear against one another, the chamfers (9) of two half-shells (5a, 5b) forming a depression (10) for receiving the casting compound (6).

6. Electronic module according to one of claims 1 to 5,
**characterized in that** the electronic components (3) are screwed to the half-shells (5a, 5b).

7. Electronic module according to claim 6,
**characterized in that** the half-shells (5a,5b) have respective threaded holes (7) in which screws extending through through-holes (8) in the electronic components (3) engage.

8. Electronic module according to any one of claims 1 to 7,
**characterized in that** the half-shells (5a, 5b) are formed as zinc die-cast components.

9. Electronic module according to any one of claims 1 to 7,
**characterized in that** the half-shells (5a, 5b) are formed as aluminium die-cast components.

10. Power tool having an electronic module (1) according to one of the claims 1 to 9.

## Revendications

1. Module électronique (1) pour un outil électrique, avec une carte (2) sur laquelle sont disposés plusieurs composants électroniques (3), avec un élément récepteur en forme de cuvette (4) destiné à recevoir la carte (2) et avec un élément de refroidissement (5) destiné à refroidir les composants électroniques (3),
dans lequel
la carte (2) est disposée à l'intérieur de l'élément récepteur en forme de cuvette (4) de telle sorte, que
un bord supérieur (4a) de l'élément récepteur en forme de cuvette (4) dépasse la carte (2) en hauteur, dans lequel
la carte (2) est scellée au moyen d'une masse de scellement (6) dans l'élément récepteur en forme de cuvette (4), **caractérisé en ce que** l'élément de refroidissement (5) est noyé dans la masse de scellement (6) et **en ce que** l'élément de refroidissement (5) se compose de deux demi-coquilles (5a, 5b) en contact l'une avec l'autre, les composants électroniques (3) étant reliés à au moins une des demi-coquilles (5a, 5b) et étant disposés à l'intérieur d'une enveloppe (5c) formée par les demi-coquilles (5a, 5b).

2. Module électronique selon la revendication 1,
**caractérisé en ce que** les composants électroniques (3) reliés à au moins une des demi-coquilles (5a, 5b) sont des éléments de commutation électroniques (3a) et/ou des redresseurs (3c).

3. Module électronique selon la revendication 2,
**caractérisé en ce qu'**au moins un composant électronique (3) est relié à chacune des deux demi-coquilles (5a, 5b), et **en ce qu'**au moins un condensateur (3b) est disposé entre les composants électroniques (3) reliés aux demi-coquilles (5a, 5b).

4. Module électronique selon la revendication 1, 2 ou 3,
**caractérisé en ce que** la zone dans laquelle les demi-coquilles (5a, 5b) sont en contact l'une avec l'autre est scellée par la masse de scellement (6).

5. Module électronique selon la revendication 4,
**caractérisé en ce que** les demi-coquilles (5a, 5b) sont pourvues chacune de chanfreins (9) dans la zone dans laquelle elles sont en contact l'une avec l'autre, les chanfreins (9) des deux demi-coquilles (5a, 5b) formant un renfoncement (10) destiné à recevoir la masse de scellement (6).

6. Module électronique selon l'une des revendications 1 à 5,
**caractérisé en ce que** les composants électroniques (3) sont vissés sur les demi-coquilles (5a, 5b).

7. Module électronique selon la revendication 6,
**caractérisé en ce que** les demi-coquilles (5a, 5b) possèdent chacune des taraudages (7) dans lesquels pénètrent des vis passant dans des perçages débouchants (8) ménagés dans les composants électroniques (3).

8. Module électronique selon l'une des revendications 1 à 7,
**caractérisé en ce que** les demi-coquilles (5a, 5b) sont réalisées sous la forme de pièces en zinc moulé sous pression.

9. Module électronique selon l'une des revendications 1 à 7,
**caractérisé en ce que** les demi-coquilles (5a, 5b) sont réalisées sous la forme de pièces en aluminium moulé sous pression.

10. Outil électrique avec un module électronique (1) selon l'une des revendications 1 à 9.
